# EUROPEAN PATENT SPECIFICATION

(11) **EP 2 725 375 B1**
(45) Date of publication and mention of the grant of the patent: **31.05.2017**
(21) Application number: 12803242.2
(22) Date of filing: 21.06.2012
(51) Int. Cl.: G01R 33/02, G01R 33/00

(54) **MAGNETIC FIELD DETECTION METHOD AND MAGNETIC FIELD DETECTION CIRCUIT**
MAGNETFELDERKENNUNGSVERFAHREN UND MAGNETFELDERKENNUNGSSCHALTUNG
PROCÉDÉ ET CIRCUIT DE DÉTECTION DE CHAMP MAGNÉTIQUE

(30) Priority: 22.06.2011 JP 2011138261
(43) Date of publication of application: 30.04.2014
(73) Proprietor: Canon Denshi Kabushiki Kaisha, Chichibu-shi, Saitama 369-1892 (JP)
(72) Inventor: KAWASE, Masahiro, Saitama 369-1892 (JP)
(74) Representative: TBK
(86) International application number: PCT/JP2012/004021
(87) International publication number: WO 2012/176451

(56) References cited:
- EP-A1- 1 146 346
- EP-A1- 1 528 402
- EP-A1- 2 199 814
- EP-A2- 0 990 919
- JP-A- 2000 111 627
- JP-A- 2000 258 517
- JP-A- 2002 243 816
- JP-A- 2003 121 517
- JP-A- 2003 329 745
- JP-A- 2004 045 246
- JP-A- 2006 284 307
- JP-A- 2007 089 142
- US-A1- 2004 008 026
- US-A1- 2004 124 835
- US-B1- 6 229 307
- CHIESI L ET AL: "CMOS planar 2D micro-fluxgate sensor", SENSORS AND ACTUATORS A, ELSEVIER SEQUOIA S.A., LAUSANNE, CH, vol. 82, no. 1-3, 1 May 2000 (2000-05-01), pages 174-180, XP004198258, ISSN: 0924-4247, DOI: 10.1016/S0924-4247(99)00360-X

## Description

### TECHNICAL FIELD

The present invention relates to a magnetic field detection method and magnetic field detection circuit for driving, with a low current consumption, a magnetism detection element in which a coil is wound around or placed close to a magnetic material.

### BACKGROUND ART

Recently, a magnetic field sensor for obtaining an azimuth by sensing the terrestrial magnetism and a current sensor for sensing a magnetic field from an electric current are often operated by solar power generation or small-sized batteries, and so demands have arisen for driving these sensors with a lower power consumption.

A magnetism detection element in which a coil is wound around or placed close to a magnetic material is called a magneto-impedance element or orthogonal fluxgate sensor in scientific societies and the like. A high-frequency electric current is supplied to the magnetic material of the magnetism detection element, and the internal magnetic flux of the magnetic material is changed by an external magnetic field based on this high-frequency electric current, thereby detecting the magnitude and direction of the external magnetic field based on a change in amplitude of an induced output generated in the coil.

When detecting a micro terrestrial magnetism or direct current, a change in voltage at a zero point indicating a zero magnetic field must be small. Therefore, a magnetic field detection circuit as disclosed in PTL 1 by the present applicant has been proposed as a detection circuit of the magnetism detection element.

In PTL 1, electric currents are evenly applied to the magnetic material in the plus and minus directions by using a pulse signal that repeats high H and low L by a high-frequency electric current. Then, hysteresis-free magnetic field detection with a stable zero point is realized by capturing a change in signal pertaining to the rising and falling edges of the pulse.

More specifically, a detection signal obtained by a change in magnetic flux in the magnetic material, which is generated at the rising and falling edges of the pulse, is superposed on a peak waveform appearing on the coil side due to capacitive coupling between the magnetic material and coil, and extracted by wave detection. Since a diode is used in this wave detection, the temperature characteristic of a forward voltage changes, but the stability of the zero point is secured by canceling the change by obtaining a wave detection midpoint between the plus and minus sides.

### CITATION LIST

### PATENT LITERATURE

PTL 1: Japanese Patent Laid-Open No. 2004-045246
PTL 2: Japanese Patent Laid-Open No. 2000-258517
PTL 3: International Publication No. 2005/19851

### SUMMARY OF INVENTION

### TECHNICAL PROBLEM

In this method, however, an electric current always flows by repeating high H and low L of the pulse signal, so an improvement for the demands for low-current-consumption driving is necessary.

As described in PTL 2 and PTL 3, it is only necessary to simply apply a narrow pulse in the method of performing intermittent driving for a low current consumption. To stably detect the zero point without any hysteresis, however, the idea of PTL 1 in which electric currents flow in the plus and minus directions is necessary, but PTL 2 and PTL 3 do not have this idea. In evidence, hysteresis clearly appears in experimental data shown in Fig. 2 of PTL 2.

Also, when performing intermittent driving as described in PTL 2 and PTL 3, the temperature characteristic of the diode in the forward direction is bad, so wave detection by a sample-and-hold circuit using an analog switch is used. Therefore, an improvement can be made in this portion, but a resistor and capacitor are necessary to adjust timings. Accordingly, the timings themselves vary due to the time constants of the resistor and capacitor, or the timings shift due to the temperature changes of the time constants. This may lead to a variation in sensitivity or a decrease in temperature characteristic.

It is an object of the present invention to solve the above-described problem, and provide a magnetic field detection method and magnetic field detection circuit in which intermittent driving is performed while electric currents are evenly applied in the plus and minus directions, no timing adjustment is necessary, the sensitivity and the stability of a zero point can be secured, and the circuit configuration is not complicated.

### SOLUTION TO PROBLEM

A magnetic field detection method according to the present invention for achieving the above object is characterized by comprising a step of applying a high-frequency pulse and a pulse delayed from the high-frequency pulse by a predetermined time to two ends of a magnetic material of a magnetism detection element in which a coil is wound around or placed close to the magnetic material, thereby intermittently supplying a plus electric current and a minus electric current to the magnetic material, and a step of detecting a magnetic flux change of the magnetic material, which corresponds to a rising edge and falling edge of the delayed pulse, by using the coil.

Also, a magnetic field detection circuit according to the present invention is characterized by comprising a magnetism detection element in which a coil is wound around or placed close to a magnetic material, a circuit configured to apply a high-frequency pulse voltage to one end of the magnetic material, a circuit configured to apply a pulse voltage delayed from the pulse to the other end of the magnetic material, and a circuit configured to detect a voltage generated in the coil in response to a rising edge and falling edge of the delayed pulse, and output a signal corresponding to strength of an external magnetic field based on a detection result.

### ADVANTAGEOUS EFFECTS OF INVENTION

In the magnetic field detection method and magnetic field detection circuit according to the present invention, electric currents evenly flow in the plus and minus directions by intermittent driving, and wave detection is performed based on the rising and falling edges of a delay-side pulse. Consequently, no timing adjustment is particularly necessary, a stable zero point can be ensured, and magnetic field detection can be performed with a low current consumption.

Furthermore, the accuracy and temperature characteristic can be secured in wave detection by a diode without using any active analog switch. Since this decreases the circuit scale, it is possible to realize magnetic field detection superior in size and cost as well.

### BRIEF DESCRIPTION OF DRAWINGS

Fig. 1 is a view showing the arrangement of a magnetic field detection circuit;
Fig. 2 is a timing chart showing application voltages and output voltages;
Fig. 3 is a perspective view of a magnetism detection element;
Fig. 4 is a view for explaining an internal domain structure when a magnetic material is viewed from above;
Fig. 5 is a detected waveform chart at the coil end before wave detection;
Fig. 6 is a detected waveform chart at the coil end on a delay side when a pulse is applied; and
Fig. 7 is a graph of measurement data of magnetic field detection.

### DESCRIPTION OF EMBODIMENTS

The present invention will be explained in detail based on embodiments shown in the drawings.

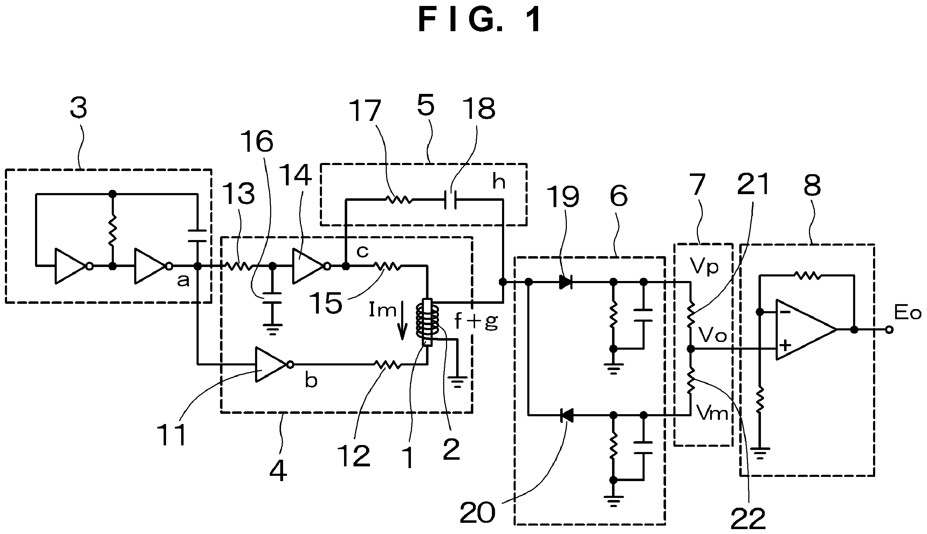

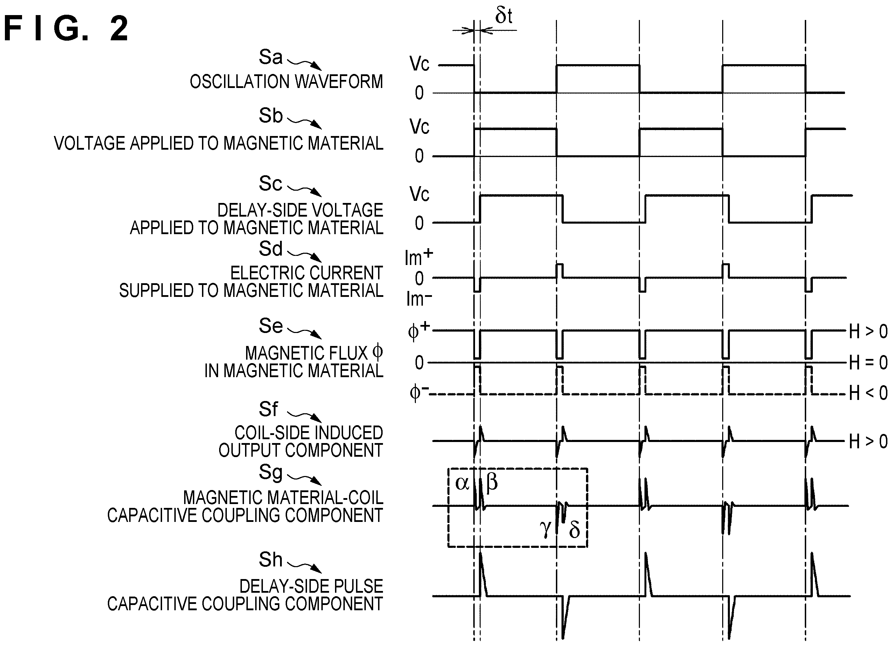

Fig. 1 is a circuit diagram of a magnetic field detection circuit for a magnetism detection element in which a coil 2 is wound around or placed close to a magnetic material 1. Fig. 2 is a timing chart showing the relationship between waveforms.

The magnetic material 1 is a wire member or thin copper plate such as an amorphous material, or a thin magnetic film formed on a nonmagnetic substrate. The coil 2 is obtained by winding a copper wire around the magnetic material 1, or placing or stacking a spiral planar coil close to or on the magnetic material 1.

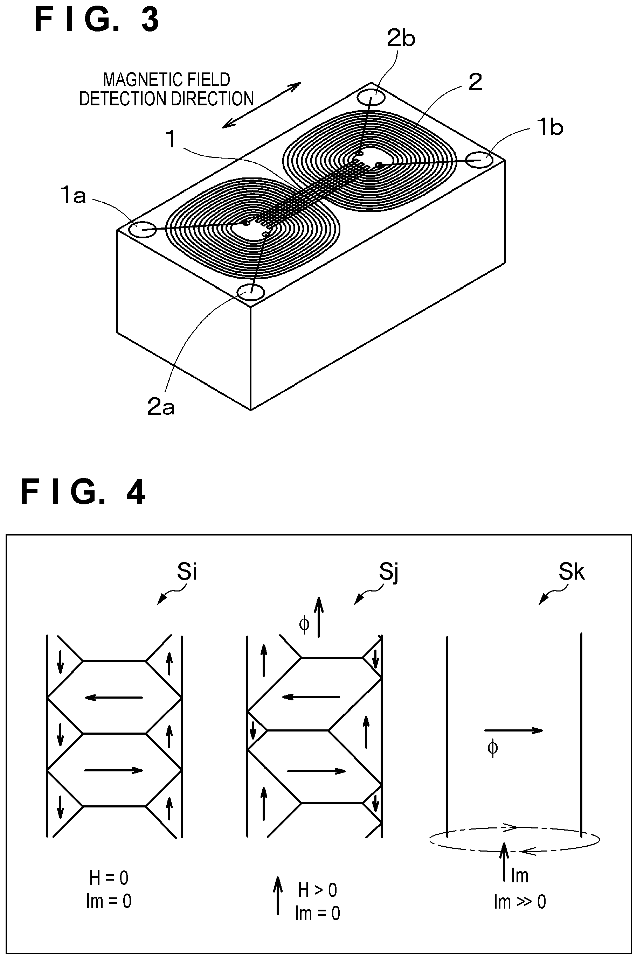

In the magnetism detection element of the embodiment as shown in Fig. 3, a plurality of long 2-µm thick Fe-Ta-C-based thin magnetic films are arranged parallel on a ceramic substrate as the magnetic material 1, and electrically connected zigzag in series. The resistance value between two ends 1a and 1b is 230 Ω. Also, the coil 2 is formed by stacking a spiral planar coil made of a copper foil on the magnetic material 1 with an insulating film (not shown) being sandwiched between them. The number of turns between coils 2a and 2b is 73 T.

Referring to Fig. 1, the output of an oscillator 3 is connected to a magnetism detector 4, and the output of the magnetism detector 4 is sequentially connected to a peak emphasizer 5, wave detector 6, voltage divider 7, and amplifier 8.

The oscillator 3 includes a C-MOS inverter and a CR circuit including a resistor R and capacitor C, and has an oscillation frequency of 2 MHz. As indicated by Sa in Fig. 2, an output a from the oscillator 3 has the waveform of a high-frequency pulse that repeats high H and low L.

In the magnetism detector 4, one part of the output a from the oscillator 3 is connected to one end of the magnetic material 1 via an inverter 11 and resistor 12. The other part of the output a from the oscillator 3 is connected to the other end of the magnetic material 1 via a resistor 13, inverter 14, and resistor 15, and grounded via a capacitor 16 between the resistor 13 and inverter 14. The other part of the output a from the oscillator 3 is delayed by a delay time δt by a CR delay circuit including the resistor 13 and capacitor 16, and input to the inverter 14. Thus, the CR delay circuit outputs an input pulse (high-frequency pulse voltage) by adding time delay. Outputs b and c from the inverters 11 and 14 are as indicated by Sb and Sc, respectively, in Fig. 2, and connected to the two end portions of the magnetic material 1. Note that the embodiment uses the inverters 11 and 14, but no problem arises even when using a non-inverting buffer type elements.

In the magnetism detector 4, an electric current Im flowing through the magnetic material 1 is adjusted to have a predetermined current value by the resistors 12 and 15, and electric currents Im⁺ and Im⁻ are intermittently alternately generated as indicated by Sd in Fig. 2, thereby obtaining even electric currents in the plus and minus directions. To guarantee this feature, it is favorable to use inverters having the same output current standard and the same propagation delay time as the inverters 11 and 14.

When a magnetic field exists outside the magnetic material 1, a magnetic flux is generated inside the magnetic material 1 and changes in synchronism with the electric current Im flowing through the magnetic material 1. This will be explained in more detail below. Si in Fig. 4 is a schematic view of an internal domain structure when viewed from above the thin-film magnetic material 1 with zero field strength. When a field strength H is applied in the longitudinal direction indicated by an arrow as indicated by Sj in Fig. 4, the magnetization of the directional component increases, and a magnetic flux φ is generated in the field application direction as a sum total.

When the electric current Im is supplied to the magnetic material 1, a contour magnetic field is generated, and the magnetization is arranged in the widthwise direction. When the electric current Im is sufficiently large, saturation occurs in the widthwise direction as indicated by Sk in Fig. 4 regardless of the direction of the field strength H, so the magnetic flux φ in the field application direction as the longitudinal direction becomes zero. Although not shown, when the electric current Im flows in the opposite direction, the magnetic flux φ in the widthwise direction is generated in the opposite direction, but the magnetic flux φ in the field application direction similarly becomes zero. That is, the original magnetic flux φ is generated only when no electric current Im flows.

Se in Fig. 2 shows that changes in magnetic flux φ are φ⁺, 0, and φ⁻ when the states of the strength H of the external magnetic field are > 0, = 0, and < 0, respectively.

The coil 2 having a predetermined number of turns is stacked on the magnetic material 1, and one end of the coil 2 is grounded. As indicated by a waveform Sf in Fig. 2, an induced output f proportional to the product of the number of turns of the coil 2 and the time derivative of the magnetic flux φ is obtained from the other end of the coil 2. Also, an induced output g indicated by Sg in Fig. 2 is superposed on the component of the induced output f. The induced output g is obtained by capacitive coupling that occurs because the magnetic material 1 and coil 2 are arranged close to each other, and only high-frequency components at the rising and falling edges of the outputs a and b indicated by Sa and Sb in Fig. 2 are parasitic on the induced output g.

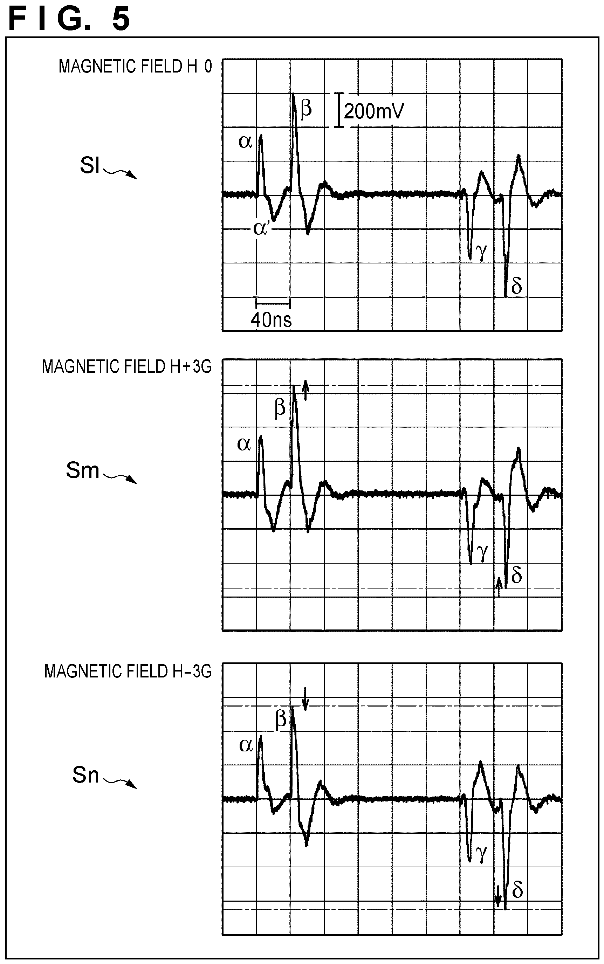

S1 to Sn shown in Fig. 5 are detected waveform charts based on waveforms obtained by experiments on the side of the coil 2. S1 in Fig. 5 shows a waveform when the field strength H is zero immediately before the wave detector 6 shown in Fig. 1. Since no magnetic flux φ is generated in the magnetic material 1 in this state, there is no induced output f indicated by Sf in Fig. 2, and only the induced output g indicated by Sg in Fig. 2 which is parasitic from the rising and falling edges of the outputs a and b indicated by Sa and Sb in Fig. 2 appears.

Although the peak of the waveform on the delay side is large in the embodiment, the result is sometimes opposite depending on the routing or the internal capacitance distribution of the magnetism detection element. In Fig. 5, the peaks are given symbols α, β, γ, and δ in this order from the left for convenience, and made to correspond to peak positions in a portion enclosed with the broken lines in Sg of Fig. 2.

When 3 G (Gauss) is applied to the field strength H in the plus direction from this state, the waveform becomes Sm shown in Fig. 5. When this waveform is observed closely, almost no changes appear in the peaks α and γ pertaining to the rising and falling edges on the non-delayed side, and changes appear in the peaks β and δ pertaining to the rising and falling edges on the delayed side. This tendency applies to the waveform of Sn shown in Fig. 5 for which the field strength H is in the opposite direction.

This is so probably because a temporal change on a side approaching zero and that on a side separating from zero are different in the magnetic flux change in the magnetic material 1 indicated by Se in Fig. 2, so the peak positions pertaining to the rising and falling edges on the non-delayed side do not match the peak of the magnetic flux change, and this makes it impossible to accurately extract the output. What is important is that the relationship between the peak positions pertaining to the rising and falling edges on the delay side and the position of the peak of the magnetic flux change in which the magnetic flux φ returns from zero to the original magnetic flux φ facilitates extracting a signal.

Also, it should be noted that if the delay time δt is too short, it is necessary to prevent interference between a small peak α' next to the peak α and the peak β to be extracted, when viewed from S1 in Fig. 5. The small peak α' is a damped wave of the peak α, which appears when capacitive coupling occurs, and has no essential relationship with the magnetic material 1. As the delay time δt, it is necessary to secure a time 1.5 times the time from the peak α to the small peak α'. Therefore, the delay time δt is preferably 30 ns or more, and set at 40 ns in this embodiment.

The peak voltage does not always satisfy β > α and δ < γ depending on the routing of the circuit board or the variation in internal capacitance distribution of the magnetism detection element. Accordingly, it is possible to make the peak voltage more reliably hold β > α and δ < γ by injecting, in the wave detector 6, a peak waveform h pertaining to the rising and falling edges as shown in Fig. 2(h) based on the output c on the delay side, by using a resistor 17 and capacitor 18 of the peak emphasizer 5.

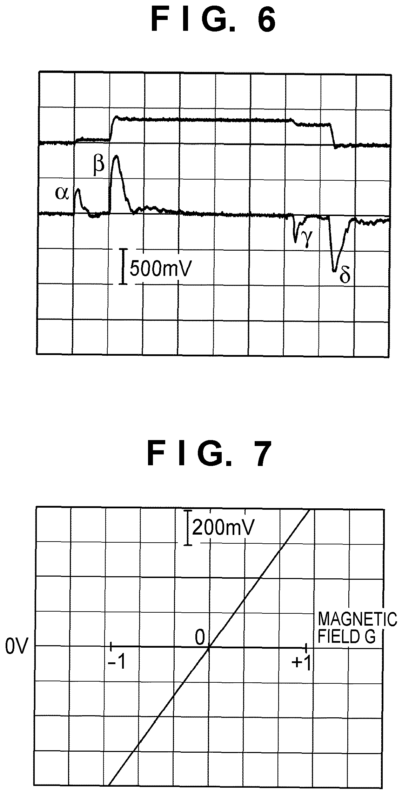

The resistor 17 and capacitor 18 are used not to perform timing adjustment but to emphasize the peaks β and δ. Fig. 6 is a detected waveform chart at the coil end connected to the 1-kΩ resistor 17 and 33-pF capacitor 18. The upper waveform is the output c on the delay side indicated by Sc in Fig. 2, and the lower waveform is the detected waveform at the end of the coil 2. Although the ordinate is changed from 200 mV/div to 500 mV/div, the peaks β and δ are obviously emphasized.

When the peak voltage satisfy β > α and δ < γ, the peaks β and δ based on the baseline are preferentially detected even in wave detection by diodes 19 and 20 of the wave detector 6, and a peak voltage Vp of the plus peak β and a peak voltage Vm of the minus peak are obtained.

As shown in Fig. 5, the peaks β and δ generated by an external magnetic field shift together in the same vertical direction with respect to the magnetic field. By setting a divided voltage at the midpoint by resistors 21 and 22 of the voltage divider 7, output Eo = (Vp + Vm)/2 of the magnetism detection element as a magnetic field sensor can be obtained through the amplifier 8 based on the ground voltage.

Although temperature changes in the forward direction of the diodes 19 and 20 of the wave detector 6 are large, the resistors 21 and 22 of the voltage divider 7 symmetrically fluctuate with respect to the baseline, so the fluctuations can be canceled by obtaining an output Vo from the midpoint by the voltage divider 7, and it is not particularly necessary to use any analog switch.

As indicated by S1 in Fig. 5, when the field strength H is zero, the peak voltage Vp of the peak β and the peak voltage Vm of the peak δ are equal, so the output Eo of the magnetic field detection circuit is 0.

Also, output Eo > 0 when the field strength H is applied in the plus direction as indicated by Sm in Fig. 5, and the magnitude of this output represents the magnitude of the field strength H. In addition, Eo < 0 when the magnetic field is applied in the minus direction as indicated by Sn in Fig. 5, and the magnitude of this output represents the magnitude of the field strength H.

The delay time δt fluctuates due to variations in time constants or temperature changes pertaining to the resistor 17 and capacitor 16 of the peak emphasizer 5 shown in Fig. 1. However, this fluctuation in delay time δt has no influence at all because the wave detector 6 is formed based on the rising and falling edges on the delay side.

Fig. 7 is a graph of measurement data of magnetic field detecting in this state shown in Fig. 6. The resistance of the magnetic material 1 made of a magnetic film of the magnetism detection element was set at 230 Ω, the period of a pulse output from the oscillator 3 by 3.3-V driving was set at 2 MHz, and the pulse delay time δt was set at 40 ns. Also, the amplification gain was 101 times.

As the current consumption, it was possible to reduce the output from the magnetic field detection circuit from 12 mA as a conventional value to 2 mA without decreasing the field detection sensitivity because no intermittent driving was performed. The current consumption can further be reduced by further shortening the pulse delay time δt, or increasing the resistance of the magnetic material 1.

In the embodiment, the strength H of an external magnetic field was reciprocally applied by a sine wave, but the linearity was high, and no hysteresis was found at all in this scale. This demonstrates that the effect of evenly applying the electric current Im in the plus and minus directions was maintained.

### REFERENCE SIGNS LIST

- 1...: magnetic material
- 2...: coil
- 3...: oscillator
- 4...: magnetism detector
- 5...: peak emphasizer
- 6...: wave detector
- 7...: voltage divider
- 8...: amplifier

## Claims

1. A magnetic field detection method comprising the following steps:
a) applying a first high-frequency pulse (S_{b}) to one end of a magnetic material (1) of a magnetism detection element in which a coil (**2**) is wound around or placed close to the magnetic material (**1**), and
b) detecting a magnetic flux (**φ**) change of the magnetic material (1) by using the coil (2),
**characterised in that**:
- the step a) further includes applying a second high-frequency pulse (S_{c}) delayed from said first high-frequency pulse (S_{b}) by a predetermined time (δt) to the other end of the magnetic material (1), thereby intermittently supplying a plus electric current and a minus electric current (S_{d}) to the magnetic material (1), and **in that**
- the magnetic flux (φ) change of the magnetic material detected in step b) corresponds to a rising edge and a falling edge of the delayed pulse.

2. A magnetic field detection method according to claim 1, **characterized by** further comprising a step of obtaining a midpoint of peak voltages at the rising edge and falling edge of the delay pulse, thereby obtaining a magnitude and direction of an external magnetic field applied to the magnetic material (**1**).

3. A magnetic field detection method according to claim 1 or 2, **characterized in that** the delay time of the pulse is not less than 30 ns.

4. A magnetic field detection method according to any one of claims 1 to 3, **characterized in that** rising directions of the high-frequency pulse and the delayed pulse are the same direction, and falling directions of the high-frequency pulse and the delayed pulse are the same direction.

5. A magnetic field detection method according to anyone of claims 1 to 4, further comprising
a step of emphasizing by a peak emphasizing unit (**5**) an output obtained by applying the pulse delayed from the high-frequency pulse by the predetermined time,
wherein the step of detecting a magnetic flux change of the magnetic material (**1**) comprises detecting the magnetic flux change of the magnetic material (**1**) in a peak waveform emphasized by the peak emphasizing unit (**5**).

6. A magnetic field detection method according to claim 5, wherein one end of the coil (**2**) is connected to an output side of the peak emphasizing unit (**5**) and the other end of the coil (**2**) is grounded.

7. A magnetic field detection circuit comprising:
a magnetism detection element in which a coil (**2**) is wound around or placed close to a magnetic material (**1**);
a first circuit (3, 11, 12) configured to apply a first high-frequency pulse (S_{b}) to one end of said magnetic material (**1**); and
a circuit (6, 7, 8) configured to detect a voltage generated in said coil (**2**) and output a signal corresponding to the strength of an external magnetic field based on a detection result,
**characterised in that**:
the magnetic field detection circuit further comprises a second circuit (3, 13, 16, 14, 15) configured to apply a second high-frequency pulse (S_{c}), delayed from said first high-frequency pulse (S_{b}) by a predetermined time (δt), to the other end of said magnetic material (1); and **in that**
the voltage generated in said coil (2) is detected in response to a rising edge and a falling edge of the delayed pulse.

8. A magnetic field detection circuit according to claim 7, **characterized in that** the signal corresponding to the strength of the external magnetic field is obtained from a midpoint of peak voltages at the delayed rising edge and falling edge.

9. A magnetic field detection circuit according to claim 7 or 8, **characterized in that** an output of the delayed pulse is applied to a circuit (5) connected by a resistor (17) and a capacitor (18) to an end portion on a wave detection side of said coil (**2**).

10. A magnetic field detection circuit according to any one of claims 7 to 9, **characterized in that** rising directions of the high-frequency pulse and the delayed pulse are the same direction, and falling directions of the high-frequency pulse and the delayed pulse are the same direction.

11. A magnetic field detection circuit according to any one of claims 7 to 10, further comprising
a peak emphasizing unit (**5**) configured to emphasize an output obtained by applying the pulse delayed from the high-frequency pulse by the predetermined time,
wherein the circuit configured to detect a voltage is further configured to detect a voltage generated in the coil (**2**) in response to the rising edge and falling edge of the delayed pulse in a peak waveform emphasized by the peak emphasizing unit (**5**).

12. A magnetic field detection circuit according to claim 11, wherein one end of the coil (**2**) is connected to an output side of the peak emphasizing unit (**5**) and the other end of the coil is grounded (**2**).

## Patentansprüche

1. Magnetfelderfassungsverfahren mit den folgenden Schritten:
a) Anlegen eines ersten Hochfrequenzimpulses (**S_{b}**) an ein Ende eines magnetischen Materials (**1**) eines Magnetismuserfassungselements, bei dem eine Spule (**2**) um das oder nahe an dem magnetischen Material (**1**) gewickelt ist, und
b) Erfassen einer Änderung eines Magnetflusses (**φ**) des magnetischen Materials (**1**) durch Verwendung der Spule (**2**),
**dadurch gekennzeichnet, dass**:
- der Schritt a) weiterhin Anlegen eines zweiten Hochfrequenzimpulses (**S_{c}**), der gegenüber dem ersten Hochfrequenzimpulses (**S_{b}**) um eine vorbestimmte Zeit (**δt**) verzögert ist, an das andere Ende des magnetischen Materials (**1**) aufweist, wodurch intermittierend eine elektrischer Plusstrom und ein elektrischer Minusstrom (**Sd**) dem magnetischen Material (**1**) zugeführt wird, und dass
- die in Schritt b) erfasste Änderung des Magnetflusses (**φ**) des magnetischen Materials einer ansteigenden Flanke und einer abfallenden Flanke des verzögerten Impulses entspricht.

2. Magnetfelderfassungsverfahren nach Anspruch 1, weiterhin **gekennzeichnet durch** einen Schritt des Erhaltens eines Mittelpunkts von Spitzenspannungen an der ansteigenden Flanke und der abfallenden Flanke des verzögerten Impulses, wodurch ein Betrag und eine Richtung eines an das magnetische Material (**1**) angelegten externen Magnetfeldes erhalten werden.

3. Magnetfelderfassungsverfahren nach Anspruch 1 oder 2, **dadurch gekennzeichnet, dass** die Verzögerungszeit des Impulses nicht kleiner als 30 ns ist.

4. Magnetfelderfassungsverfahren nach einem der Ansprüche 1 bis 3, **dadurch gekennzeichnet, dass** Anstiegsrichtungen des Hochfrequenzimpulses und des verzögerten Impulses dieselbe Richtung sind, und Abfallrichtungen des Hochfrequenzimpulses und des verzögerten Impulses dieselbe Richtung sind.

5. Magnetfelderfassungsverfahren nach einem der Ansprüche 1 bis 4, weiterhin mit
einem Schritt des Hervorhebens durch eine Spitzenhervorhebungseinheit (**5**) einer Ausgabe, die durch Anlegen des gegenüber dem Hochfrequenzimpuls um die vorbestimmte Zeit verzögerten Impulses erhalten wird,
wobei der Schritt des Erfassens einer Magnetflussänderung des magnetischen Materials (**1**) Erfassen der Magnetflussänderung des magnetischen Materials (**1**) in einer durch die Spitzenhervorhebungseinheit (**5**) hervorgehobenen Spitzenwellenform aufweist.

6. Magnetfelderfassungsverfahren nach Anspruch 5, wobei ein Ende der Spule (**2**) mit einer Ausgangsseite der Spitzenhervorhebungseinheit (**5**) verbunden ist, und das andere Ende der Spule (**2**) geerdet ist.

7. Magnetfelderfassungsschaltung mit:
einem Magnetismuserfassungselement, bei dem eine Spule (**2**) um ein oder nahe an einem magnetischen Material (**1**) gewickelt ist,
einer ersten Schaltung (**3, 11, 12**), die konfiguriert ist, einen ersten Hochfrequenzimpuls (**S_{b}**) an ein Ende des magnetischen Materials (**1**) anzulegen, und
einer Schaltung (**6, 7, 8**), die konfiguriert ist, eine in der Spule (**2**) erzeugte Spannung zu erfassen und ein Signal entsprechend der Stärke eines externen Magnetfeldes auf der Grundlage eines Erfassungsergebnisses auszugeben,
**dadurch gekennzeichnet, dass**
die Magnetfelderfassungsschaltung weiterhin eine zweite Schaltung **(3, 13 ,16, 14, 15)** aufweist, die konfiguriert ist, einen zweiten Hochfrequenzimpuls (**S_{c}**), der gegenüber dem ersten Hochfrequenzimpulses (**S_{b}**) um eine vorbestimmte Zeit (**δt**) verzögert ist, an das andere Ende des magnetischen Materials (**1**) anzulegen, und dass
die in der Spule (**2**) erzeugte Spannung in Reaktion auf eine ansteigende Flanke und eine abfallende Flanke des verzögerten Impulses erfasst wird.

8. Magnetfelderfassungsschaltung nach Anspruch 7, **dadurch gekennzeichnet, dass** das Signal entsprechend der Stärke des externen Magnetfeldes von einem Mittelpunkt von Spitzenspannungen an den verzögerten ansteigenden Flanke und abfallenden Flanke erhalten wird.

9. Magnetfelderfassungsschaltung nach Anspruch 7 oder 8, **dadurch gekennzeichnet, dass** eine Ausgabe des verzögerten Impulses an eine Schaltung (**5**) angelegt wird, die durch einen Widerstand (**17**) und einen Kondensator (**18**) mit einem Endabschnitt auf einer Wellenerfassungsseite der Spule (**2**) verbunden ist.

10. Magnetfelderfassungsschaltung nach einem der Ansprüche 7 bis 9, **dadurch gekennzeichnet, dass** Anstiegsrichtungen des Hochfrequenzimpulses und des verzögerten Impulses dieselbe Richtung sind, und Abfallrichtungen des Hochfrequenzimpulses und des verzögerten Impulses dieselbe Richtung sind.

11. Magnetfelderfassungsschaltung nach einem der Ansprüche 7 bis 10, weiterhin mit
einer Spitzenhervorhebungseinheit (**5**), die konfiguriert ist, einen Ausgang hervorzuheben, der durch Anlegen des gegenüber dem Hochfrequenzimpuls um die vorbestimmte Zeit verzögerten Impulses erhalten wird,
wobei die zum Erfassen einer Spannung konfigurierte Schaltung weiterhin konfiguriert ist, eine in der Spule (**2**) erzeugte Spannung in Reaktion auf die ansteigende Flanke und die abfallende Flanke des verzögerten Impulses in einer durch die Spitzenhervorhebungseinheit (**5**) hervorgehobenen Spitzenwellenform zu erfassen.

12. Magnetfelderfassungsschaltung nach Anspruch 11, wobei ein Ende der Spule (**2**) mit einer Ausgangsseite der Spitzenhervorhebungseinheit (**5**) verbunden ist, und das andere Ende der Spule (**2**) geerdet ist.

## Revendications

1. Procédé de détection de champ magnétique comprenant les étapes suivantes :
a) appliquer une première impulsion haute fréquence (S_{b}) à une extrémité de corps magnétique (1) d'un élément de détection de magnétisme, dans lequel une bobine (2) est enroulée autour du corps magnétique (1) ou placée à proximité de celui-ci, et
b) détecter une variation de flux magnétique (φ) du corps magnétique (1) à l'aide de la bobine (2),
**caractérisé en ce que** :
- l'étape a) comporte en outre l'application d'une seconde impulsion haute fréquence (S_{c}) retardée d'un temps prédéterminé (δt) par rapport à ladite première impulsion haute fréquence (S_{b}), à l'autre extrémité du corps magnétique (1), de manière à fournir de façon intermittente un courant électrique positif et un courant électrique négatif (S_{d}) au corps magnétique (1), et **en ce que** :
- la variation de flux magnétique (φ) du corps magnétique, détectée à l'étape b) correspond à un flanc avant et un flanc arrière de l'impulsion retardée.

2. Procédé de détection de champ magnétique selon la revendication 1, **caractérisé en ce qu'**il comprend en outre une étape consistant à obtenir un point médian de tensions de crête sur le flanc avant et le flanc arrière de l'impulsion à retard, de manière à obtenir une amplitude et un sens de champ magnétique externe appliqué au corps magnétique (1).

3. Procédé de détection de champ magnétique selon la revendication 1 ou 2, **caractérisé en ce que** le temps de retard de l'impulsion n'est pas inférieur à 30 ns.

4. Procédé de détection de champ magnétique selon l'une quelconque des revendications 1 à 3, **caractérisé en ce que** les sens de montée de l'impulsion haute fréquence et de l'impulsion retardée sont les mêmes, et les sens de descente de l'impulsion haute fréquence et de l'impulsion retardée sont les mêmes.

5. Procédé de détection de champ magnétique selon l'une quelconque des revendications 1 à 4, comprenant en outre :
une étape consistant à accentuer au moyen d'une unité d'accentuation de crête (5) une sortie obtenue par application de l'impulsion retardée du temps prédéterminé par rapport à l'impulsion haute fréquence,
dans lequel l'étape de détection d'une variation de flux magnétique du corps magnétique (1) comprend la détection de la variation de flux magnétique du corps magnétique (1) dans une forme d'onde de crête accentuée par l'unité d'accentuation de crête (5).

6. Procédé de détection de champ magnétique selon la revendication 5, dans lequel une extrémité de la bobine (2) est reliée à un côté sortie de l'unité d'accentuation de crête (5) et l'autre extrémité de la bobine (2) est mise à la terre.

7. Circuit de détection de champ magnétique comprenant :
un élément de détection de magnétisme dans lequel une bobine (2) est enroulée autour d'un corps magnétique (1) ou placée à proximité de celui-ci ;
un premier circuit (3, 11, 12) conçu pour appliquer une première impulsion haute fréquence (S_{b}) à une extrémité dudit corps magnétique (1) ; et
un circuit (6, 7, 8) conçu pour détecter une tension engendrée dans ladite bobine (2) et délivrer un signal correspondant à l'intensité d'un champ magnétique externe, en fonction d'un résultat de détection,
**caractérisé en ce que** :
le circuit de détection de champ magnétique comprend en outre un second circuit (3, 13, 16, 14, 15) conçu pour appliquer une seconde impulsion haute fréquence (S_{c}) retardée d'un temps prédéterminé (δt) par rapport à ladite première impulsion haute fréquence (S_{b}), à l'autre extrémité dudit corps magnétique (1) ; et **en ce que** :
la tension engendrée dans ladite bobine (2) est détectée en réponse à un flanc avant et un flanc arrière de l'impulsion retardée.

8. Circuit de détection de champ magnétique selon la revendication 7, **caractérisé en ce que** le signal correspondant à l'intensité du champ magnétique externe est obtenu à partir d'un point médian de tensions de crête sur le flanc avant et le flanc arrière retardés.

9. Circuit de détection de champ magnétique selon la revendication 7 ou 8, **caractérisé en ce qu'**une sortie de l'impulsion retardée est appliquée à un circuit (5) connecté par une résistance (17) et un condensateur (18) à une partie d'extrémité d'un côté détection d'ondes de ladite bobine (2).

10. Circuit de détection de champ magnétique selon l'une quelconque des revendications 7 à 9, **caractérisé en ce que** les sens de montée de l'impulsion haute fréquence et de l'impulsion retardée sont les mêmes, et les sens de descente de l'impulsion haute fréquence et de l'impulsion retardée sont les mêmes.

11. Circuit de détection de champ magnétique selon l'une quelconque des revendications 7 à 10, comprenant en outre :
une unité d'accentuation de crête (5) conçue pour accentuer une sortie obtenue par application de l'impulsion retardée du temps prédéterminé par rapport à l'impulsion haute fréquence,
dans lequel le circuit conçu pour détecter une tension est conçu en outre pour détecter une tension engendrée dans la bobine (2) en réponse au flanc et au flanc arrière de l'impulsion retardée dans une forme d'onde de crête accentuée par l'unité d'accentuation de crête (5).

12. Circuit de détection de champ magnétique selon la revendication 11, dans lequel une extrémité de la bobine (2) est reliée à un côté sortie de l'unité d'accentuation de crête (5) et l'autre extrémité de la bobine (2) est mise à la terre.
